# EUROPEAN PATENT APPLICATION

(11) **EP 3 471 116 A1**
(43) Date of publication of application: **17.04.2019**
(21) Application number: 17810501.1
(22) Date of filing: 01.06.2017
(51) Int. Cl.: H01F 27/34, H01F 27/28, H01F 27/29, H01F 27/32, H01F 17/00

(54) **COMPLEX ELECTRONIC COMPONENT**

(30) Priority: 10.06.2016 KR 20160072557
(71) Applicant: Moda-Innochips Co., Ltd., Ansan-si, Gyeonggi-do 15433 (KR)
(72) Inventor: KIM, Gyeong Tae, Ansan-si Gyeonggi-do 15454 (KR); KIM, Sang Hyun, Gwangju-Si Gyeonggi-do 12751 (KR)
(74) Representative: Michalski Hüttermann & Partner Patentanwälte mbB
(86) International application number: PCT/KR2017/005727
(87) International publication number: WO 2017/213378

(57) **Abstract**

Provided is a complex electronic component including a noise filter part including a wire wound around a core and removing a noise signal and an ESD protecting part coupled to the noise filter part and protecting an ESD.

## Description

### TECHNICAL FIELD

The present disclosure relates to a complex electronic component, and more particularly, to a complex electronic component which is capable of ensuring a stable characteristic by being installed on a vehicle etc., and which has two or more functions.

### BACKGROUND

A common mode filter has a structure in which two choke coils are integrated into one, and which passes signal current for a differential mode and can remove only noise current in a common mode. That is, the common mode filter can classify and remove the signal current for the differential mode and the noise current in the common mode, the currents being alternating currents.

Common mode filters, in which a toroidal core is used, and in which a drum core is used, are known as such common mode filters. When a toroidal core is used, since the toroidal core has a high effective magnetic permeability, a high nose removing performance can be obtained. However, since it is difficult to automatically wind the toroidal core, there is a disadvantage of causing a large variation in characteristics. On the other hand, when a drum core is used, noise removing performance as high as that of the toroidal core is hardly obtained, but, since an automatic winding method can be used, it is possible to reduce variation in characteristics and the drum core is suitable for mass production.

Meanwhile, a common mode filter used for vehicle ethernet requires a stabler characteristic and higher noise reduction performance than typical common mode filters. Regarding this, a common mode filter of a drum core type has a merit in that variation in characteristics can be reduced, as described above, and may thereby be suitable for vehicle ethernet.

For example, in a drum core type common mode filter, a terminal electrode is formed by plating or soldering on a flange of a drum core, a pair of wires are wound around the drum core, and then, ends of the wires are soldered to the terminal electrode. Subsequently, the terminal electrode formed by plating or soldering is mounted on a wiring board of a vehicle through soldering.

In addition, in another example of the drum core type common mode filter, a "C"-shaped terminal electrode is inserted and fastened in a flange, ends of a wire are fixed by using a portion of the terminal electrode, and then, a welded part is formed on the terminal electrode by using laser welding or arc welding, whereby a common mode filter is being manufactured.

That is, in a drum core type common mode filter, the terminal electrode may be formed through plating or welding, or the terminal electrode may also be formed in a "C"-shape and inserted fastened in a flange.

Meanwhile, when a high voltage such as an external ESD voltage is applied, electronic components in a vehicle should be protected from the high voltage. However, typical common filters have no special measure with respect to an ESD voltage or the like. An insulating material for coating wires wound around a drum core can only be used as a measure for a high voltage.

However, common mode filters are gradually miniaturized, and accordingly, the diameters of wires become smaller and thereby weaker against a high voltage, and thus, the danger caused thereby becomes significant. In particular, common mode filters, mounted on vehicles, such as electric vehicles and hybrid vehicles in which a lot of electronic products are used, more and more require reliability against a high voltage such as an ESD voltage.

### [Prior Art Documents]

Japanese Patent Laid-open Publication No. 2003-022916

### DISCLOSURE OF THE INVENTION

### TECHNICAL PROBLEM

The present disclosure provides a complex electronic component having two or more functions.

The present disclosure also provides a complex electronic component having both a noise reducing function and an ESD protecting function.

The present disclosure also provides a complex electronics component capable of reducing a mounting area such that a noise filter part and an ESD protecting part are integrally manufactured.

### TECHNICAL SOLUTION

In accordance with an exemplary embodiment, a complex electronic component includes: a noise filter part including a wire wound around a core and removing a noise signal; and an ESD protecting part coupled to the noise filter unit and protecting an ESD.

The noise filter part may include: flanges provided on both end portions of the core; terminal electrodes to which the wire is upwardly led out; and welded parts provided on the terminal electrodes.

The terminal electrodes may be formed through plating or soldering or formed by being fastened to the flanges.

The wire may include a metal wire and an insulating coating for coating the metal wire, and at least a portion of the insulating coating at portions upwardly led out to the terminal electrodes may be removed.

The wire may include a metal wire and an insulating coating for coating the metal wire, and at least a portion of the insulating coating may be removed, the portions extending and being led out to the outside of the terminal electrodes and being located outside the terminal electrodes.

The insulating coating may remain between the welded parts and the terminal electrodes or in at least one region of the welded parts.

The ESD protecting part may be connected to the terminal electrodes of the noise filter part.

The ESD protecting part may be inserted between the flanges and the terminal electrodes.

The ESD protecting part may include: a support plate provided with a plurality of connecting electrodes and a plurality of led-out electrodes led out from the connecting electrodes; and an ESD protecting chip provided in a predetermined region in the support plate.

At least a portion of the plurality of connecting electrodes may be connected to the terminal electrodes and thereby mounted on a wiring board, and at least another portion the plurality of connecting electrodes may be connected to a ground terminal.

The support plate may include a mounting groove formed such that predetermined region of the led-out electrodes are exposed, and the ESD protecting chip may be mounted on the mounting groove.

The ESD protecting part may include an ESD protecting member and a plurality of connecting electrodes formed on a side surface of the ESD protecting member.

### ADVANTAGEOUS EFFECTS

A complex electronic component in accordance with an exemplary embodiment includes a noise filter part and an ESD protecting part bought into contact with terminal electrodes of the noise filter. In this case, portions of the noise filter and the ESD protecting part may be provided between signal terminals, and a portion of the ESD protecting part may be provided between ground terminals. Accordingly, noise current may be removed by the noise filter part and an ESD voltage applied from the outside may be blocked by the ESD protecting part.

In addition, in the noise filter part, flanges are provided on both end portions of a core around which a wire is wound, and for example, "C"-shaped terminal electrodes are fastened to second regions of the flanges. In addition, inclined surfaces (or rounded surfaces) are formed between front and rear surfaces in the second regions of the flanges such that the fastening of the terminal electrodes are facilitated and the cut of the wire led out to an upper surface of the terminal electrodes may be prevented. Thus, assemblability may be enhanced and productivity and quality may be improved.

### BRIEF DESCRIPTION OF THE DRAWINGS

Exemplary embodiments can be understood in more detail from the following description taken in conjunction with the accompanying drawings, in which:
FIGS. 1 and 2 are an exploded perspective view and an assembled perspective view of a complex electronic component in accordance with a first exemplary embodiment;
FIG. 3 is an exploded perspective view before welded parts of a noise filter part of a complex electronic component in accordance with a first exemplary embodiment are formed;
FIGS. 4 to 6 are structural views of terminal electrodes of noise filter parts in accordance with an exemplary embodiment and modified embodiments thereof;
FIGS. 7 to 10 are schematic views for describing a method for manufacturing an ESD protecting part of a complex electronic component in accordance with a first exemplary embodiment;
FIG. 11 is an exploded perspective view of an ESD protecting part of a complex electronic component in accordance with a first exemplary embodiment;
FIGS. 12 and 13 are an exploded perspective view and an assembled perspective view of a complex electronic component in accordance with a second exemplary embodiment;
FIGS. 14 and 15 are an exploded perspective view and an assembled perspective view of a complex electronic component in accordance with a third exemplary embodiment;
FIGS. 16 and 17 are an exploded perspective view and an assembled perspective view of a complex electronic component in accordance with a fourth exemplary embodiment;
FIG. 18 is an exploded perspective view before welding parts of a noise filter part of a complex electronic component in accordance with a fourth exemplary embodiment are formed; and
FIG. 19 is a structural view of a noise filter part in accordance with a fourth exemplary embodiment.

### MODE FOR CARRYING OUT THE INVENTION

Hereinafter, exemplary embodiments of the present invention will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

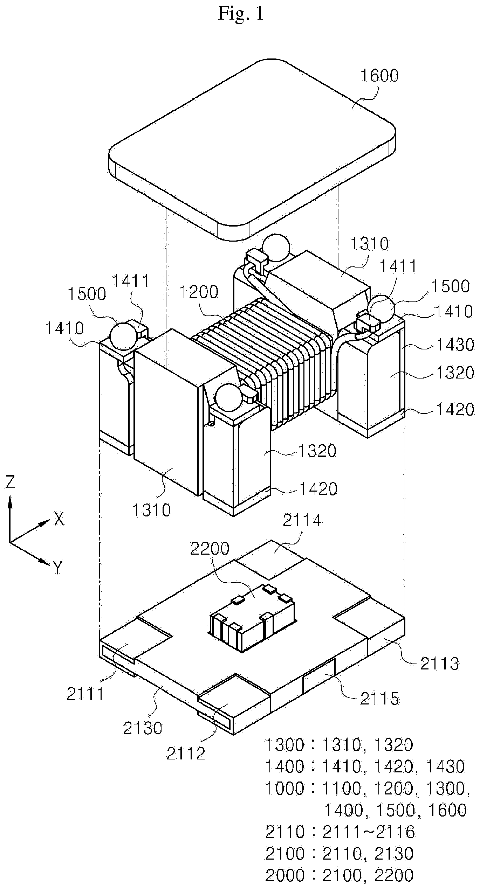

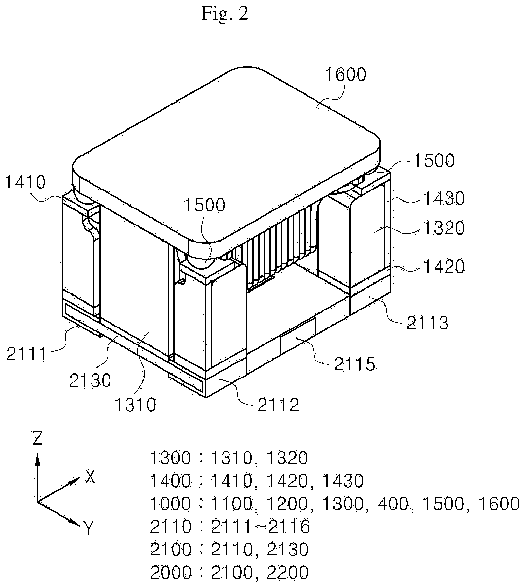

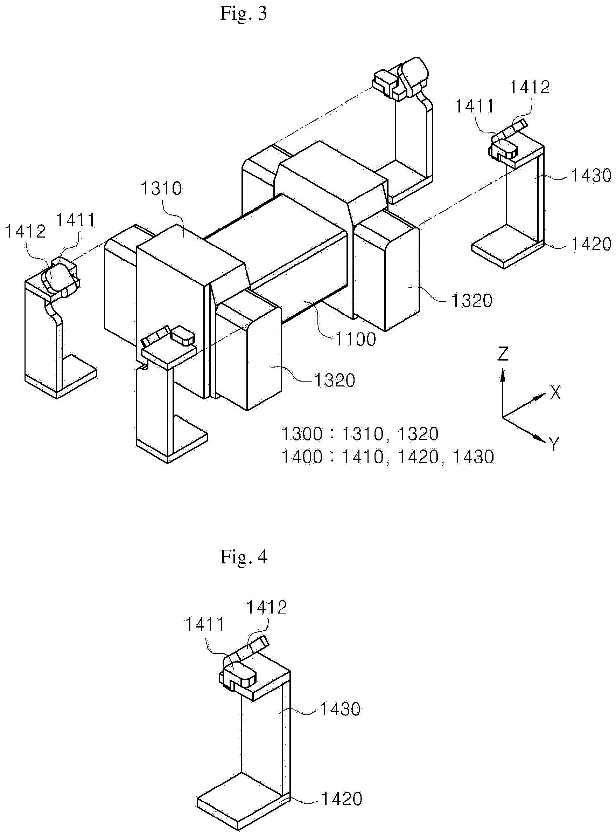

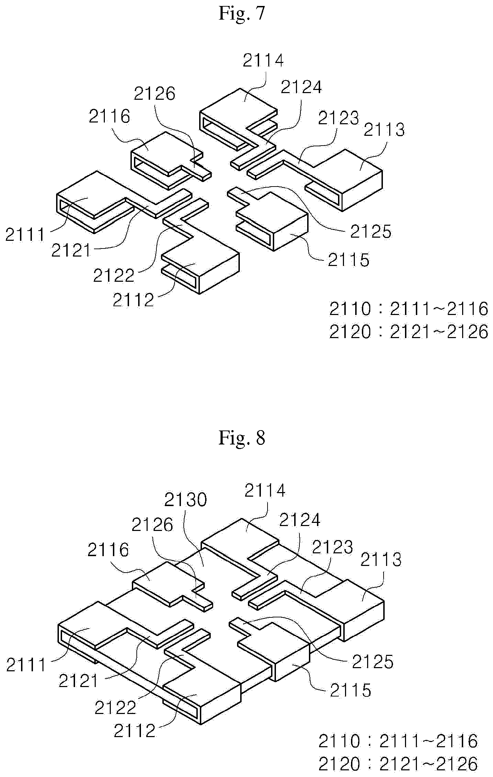

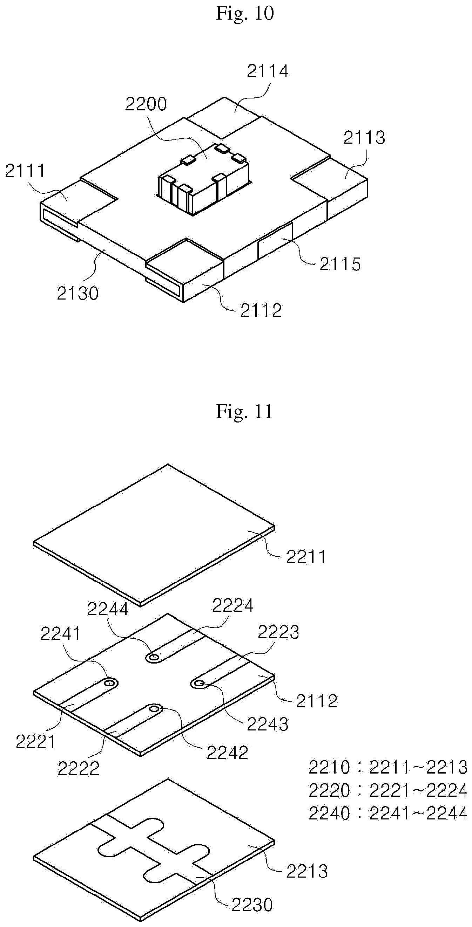

FIG. 1 is an exploded perspective view of a complex electronic component in accordance with a first exemplary embodiment and FIG. 2 is an assembled perspective view thereof. In addition, FIG. 3 is an exploded perspective view before welding parts of a noise filter part of a complex electronic component in accordance with a first exemplary embodiment are formed. In addition, FIGS. 4 to 6 are structural views of terminal electrodes of noise filter parts in accordance with an exemplary embodiment and modified embodiments thereof. In addition, FIGS. 7 to 10 are schematic views for describing a method for manufacturing an ESD protecting part of a complex electronic component in accordance with an exemplary embodiment. In addition, FIG. 11 is an exploded perspective view of an ESD protecting part of a complex electronic component in accordance with an exemplary embodiment.

Referring to FIGS. 1 to 11, a complex electronic component for a vehicle in accordance with an exemplary embodiment may include a noise filter part 1000 and an ESD protecting part 2000. Here, the ESD protecting part 2000 may be provided by being coupled to one side of the noise filter part 1000.

### 1. Noise filter part

The noise filter part 1000 may include: a core 1100; a wire wound around the core 1100; flanges 1300 provided on both end portions of the core 1100 such that both sides thereof are provided in heights lower than that of the central portion; terminal electrodes 1400 fastened to both the sides of the flanges 1300; welded parts 1500 formed on the terminal electrodes 1400; and a cover part 1600 provided on the core 1100.

### 1.1. Core

The core 1100 may be provided in an approximately hexahedral shape, and the wire 1200 may be wound to contact and surround the core 1100. For example, the core 1100 may be provided such that cross-sectional shapes respectively in the lengthwise direction (X-direction) and the width direction (Y-direction) are approximately rectangles, and the length in the X-direction is greater that the width in the Y-direction. That is, the core 1100 is provided with first and second surfaces (that is, front and rear surfaces) facing each other in the X-direction, third and fourth surfaces facing each other in the Y-direction (that is, two side surfaces), and fifth and sixth surfaces facing each other in the Z-direction (that is, upper and lower surfaces), and the distance between the first and second surfaces may be greater than the width of the third and fourth surfaces. In addition, the core 1100 may be formed to have roundly formed corner portions or to have a predetermined inclination. That is, corner portions between the third to sixth surfaces (that is, between two side surfaces and the upper and lower surfaces) may be roundly formed or formed to have a predetermined inclination. As such, the corners of the core 1100 are roundly formed, and thus, when the wire 1200 is wound, the problem of cut of the wire 1200 due to a sharp corner or the like may be prevented. Of course, the core 1100 may be provided in a cylindrical shape or may also be provided in a polyhedral shape. For example, the core 1100 may be provided such that a plane or a cross-section in the Y-direction, that is, the first and second surface may form circles or polyhedrons having more than five sides and may be provided in a predetermined length in the X-direction. Flanges 1300 may be provided on both end portions of the core 1100, that is, on the first and second surfaces in the X-direction. Meanwhile, the core 1100 may be formed of a ferrite material. One or more selected from the group consisting of Ni ferrite, Zn ferrite, Cu ferrite, Mn ferrite, Co ferrite, Ba ferrite, and Ni-Zn-Cu ferrite, or one or more oxide magnetic materials thereof may be used as the ferrite material. After such a ferrite material and, for example, a polymer are mixed, the mixture is formed in a shape such as a hexahedron, and thus, the core 1100 may be manufactured.

### 1.2. Wire

The wire 1200 may be provided to surround the core 1100. That is, the wire 1200 may be provided to surround the third to sixth surfaces from one side to the other side in the X-direction, for example, in the direction from the first surface to the second surface. In addition, the wire 1200 surrounds the core 1100 and then, both ends thereof may be led out to the upper portions of the terminal electrodes 1400 fastened to the flanges 1300. The wire 1200 may be wound on the core 1100 in at least one layer. For example, the wire 1200 may include a first wire brought into contact with and wound around the core 1100, and a second wire brought into contact with and wound on the first wire. In this case, both end portions of the first wire may extend to the upper portions of the terminal electrodes 1400 fastened to two flanges 1300 facing each other, and both end portions of the second wire may extend to the upper portions of the terminal electrodes 1400 fastened to two flanges which face each other and to which the first wire does not extend. Meanwhile, the wire 1200 may be formed of a conductive material, and an insulating material may be applied to surround the conductive material. For example, the wire 1200 may be formed such that a metal wire such as copper wire is formed in a predetermined thickness, and an insulating material such as a resin may be formed to coat the metal wire. For an insulating coating, polyurethane, polyester, polyester imide, polyamide imide, polyimide, or the like may be sorely used, or a mixture of at least two or more thereof or a laminate thereof may also be used. For example, the insulating coating may also be formed by using a mixture of polyester and polyamide or a laminate thereof may also be used. Meanwhile, the insulating coating may be removed from end portions of the wire 1200 brought into contact with the upper portions of the terminal electrodes 1400 and a portion of the metal wire may thereby be exposed. To remove at least a portion of the insulating coating, laser may be emitted at least once. For example, the end portions of the wire 1200 brought into contact with the terminal electrodes 1400 may be irradiated with laser, and thus, a portion of the insulating coating, for example, an upper portion of the insulating coating may be removed. In this case, the insulating coating may remain in the lower portion of the wire 1200, that is, a portion brought into contact with the terminal electrodes 1400. In addition, the insulating coating at the end portions of the wire 1200 brought into contact with the terminal electrodes 1400 may entirely be removed. That is, the end portions of the wire 1200 may be irradiated with first laser, and the portion irradiated with the first laser may be rotated and may then be irradiated with second laser such that the insulating coating may also be removed completely. As the insulating coating at the end portions of the wire 1200 is completely removed, the insulating coating is not present between the terminal electrodes 1400 and the wire 1200. Also, the insulating coating may remain in the portion contacting the terminal electrodes 1400, and the insulating coating at a portion out of the terminal electrodes 1400 may also be removed partially. For example, after ends of the wire 1200 may be led out to get out of the terminal electrodes 1400, the regions out of the terminal electrodes 1400 may also be irradiated with laser to remove a portion of the insulating coating of the wire 1200. Consequently, the insulating coating at one region of the wire 1200 brought into contact with the terminal electrodes 1400 may not be removed, partially removed, or completely removed.

### 1.3. Flange

The flanges 1300 are provided to both ends of the core 1100 in the X-direction. The flanges 1300 may include first regions 1310 brought into contact with the core 1100, and second regions 1320 provided to both sides of the first region 1310 in the Y-direction so as not to be in contact with the core 1100. The first and second regions 1310 and 1320 of the flanges 1300 may be formed to have predetermined widths, lengths, and heights. That is, the first and second regions 1310 and 1320 may respectively be formed such that first and second surfaces (that is, front and rear surfaces) facing each other in the X-direction have a predetermined width, third and fourth surfaces (that is, both side surfaces) facing each other in the Y-direction have a predetermined length, and fifth and sixth surfaces (that is, lower and upper surfaces) facing each other in the Z-direction have a predetermined height. In other words, the first surfaces in the direction in which the terminal electrodes 1400 are inserted serve as front surfaces and the second surfaces facing the first surfaces serve as the rear surfaces. Accordingly, the core 1100 is brought into contact with the second surfaces of the first regions 1310, that is, the rear surfaces, and the second regions 1320 are brought into contact with the third and fourth surfaces (that is, both side surfaces) of the first regions 1310. Similarly, in the second regions 1320, the first surfaces in the direction in which the terminal electrodes 1400 are inserted serve as front surfaces and the second surfaces facing the first surfaces and the core 1100 serve as the rear surfaces. Meanwhile, the first regions 1310 may be formed higher than the second regions 1320. That is, the first and second regions may be formed in such a height that after the welded parts 1500 are formed, the first regions 1310 contact the lower surface of the cover part 1600 and the welded parts 1500 in the second regions 1320 do not contact the cover part 1600. In this case, the first regions 1310 may be formed in such a height that the welded parts 1500 do not contact the cover part 1600 in consideration of the heights of the second regions 1320 and the welded parts 1500. Also, the first regions 1310 may be formed to have greater width and length than the second regions 1320. Accordingly, steps may be formed between the upper surfaces of the first regions 1310 and the upper surfaces of the second regions 1320, and steps may be formed between the front surfaces of the first regions 1310 and the front surfaces of the second regions 1320.

"C"-shaped terminal electrodes 1400 are fastened to the second regions 1320 of the flanges 1300. That is, the terminal electrodes 1400 are inserted from one side toward the other side in the X-direction and fastened to the second regions 1320 of the flanges 1300. In this case, as illustrated in FIG. 3, the portion between the upper surfaces of the second regions 1320 and the surface (that is, the front surfaces) in the direction in which the terminal electrodes 1400 are fastened may have a predetermined slope (that is, inclination). That is, in the second regions 1320, inclined regions having predetermined slopes may be formed between the front and upper surfaces, that is, between the first and sixth surfaces. In other words, edges may not be formed, but a predetermined inclination may be present between the front and upper surfaces. In this case, the inclined regions may also be roundly formed to have a predetermined curve and may be formed to have a predetermined inclination from the upper to front surfaces thereof. As such, the predetermined inclination is formed between the front and upper surfaces, the upper surfaces of the terminal electrodes 1400 may thereby be moved along the inclination, and accordingly, the terminal electrodes 1400 may be more easily fastened.

In addition, the second regions 1320 of the flanges 1300 may have not only first inclined regions with a predetermined width between the front and upper surfaces thereof (that is, between the first and sixth surfaces), but also have the second inclined regions with a predetermined width between the rear and upper surfaces thereof (that is, between the second and sixth surfaces). In this case, the second inclined regions may also be roundly formed to have a predetermined curve and may be formed to have a predetermined inclination from the upper to rear surfaces thereof. As such, the predetermined inclination is formed between the rear and upper surfaces, the wire 1200 led out toward the terminal electrodes 1400 is thereby guided along the round portions. Therefore, cuts of the wire 1200, peel-off of the coating, or the like may be prevented. That is, when edges are formed in the flanges 1300 between the rear and upper surfaces of the second regions 1320 which are brought into contact with the wire 1200 and to which the wire 1200 is led out, the coating of the wire 1200 may also be peeled off by being chopped at portions of the edges, or the wire 1200 may be cut when the wire 1200 is led out. However, the cuts of the led-out wire 1200 may be prevented by roundly forming the corresponding portions.

Meanwhile, the second inclined regions between the rear and upper surfaces of the second regions 1320 (that is, between the second and sixth surfaces) may be formed in a length of approximately 5% to approximately 20% of the length of the upper surface in the X-direction, for example, in a width of approximately 0.05 mm to approximately 0.25 mm. That is, the distance between a first virtual line extending upward from the vertical rear surface (that is, the second surface) and a second virtual line extending upward from the border between the horizontal upper surface (that is, the sixth surface) and the second inclined region may be, for example, approximately 0.05 mm to approximately 0.25 mm. In this case, when the width of the second inclined regions exceeds the above range, the area brought into contact with the terminal electrodes 1400 is reduced and thereby, the terminal electrodes 1400 may be hardly supported firmly, and when the width of the second inclined regions is less than the above range, a corner is formed in edges and thereby, there may be a problem of cuts of wire 1200 while the wire 1200 is led out. In addition, the distance from the border between the horizontal upper surface (i.e., the sixth surface) and the second inclined region to an outer side (a second side to be described later) of the upper surfaces 1410 of the terminal electrodes 1400 may be, for example, approximately 0.05 mm to approximately 0.25 mm. That is, the distance from the border between the upper surfaces of the second regions 1320 and the second inclined regions to an outer side (i.e., the second side) of the upper surfaces 1410 of the terminal electrodes 1400 may be, for example, approximately 0.05 mm to approximately 0.25 mm. In this case, as the distance from the outer side of the upper surfaces 1410 of the terminal electrodes 1400 to the border region exceeds approximately 0.25 mm and becomes greater, the size of the upper surfaces 1410 of the terminal electrodes 1400 is decreased, and the size of the welded parts 1500 formed on the upper surfaces 1410 may thereby be limited. Therefore, the distance is favorably maintained at approximately 0.25 mm or less. In addition, when the distance from the outer side of the upper surfaces 1410 of the terminal electrodes 1400 to the border region is small to be less than approximately 0.05 mm or the upper surfaces 1410 are formed to cover the second inclined region, the led-out wire 1200 is chopped by the edge of the second side of the upper surfaces 1410, and a phenomenon of cuts of the wire 1200 or peel-off of coating may be caused. Therefore, as the distance from the outer side of the upper surfaces 1410 of the terminal electrodes 1400 to the border region exceeds approximately 0.25 mm and becomes greater, the size of the upper surfaces 1410 of the terminal electrodes 1400 becomes smaller, and accordingly, the size of the welded parts 1500 formed on the upper surfaces 1410 may be limited, and thus, the distance is favorably maintained at approximately 0.05 mm or more.

Also, the folding angle of the wire 1200 may be adjusted according to the width of the second inclined region of the second regions 1320, the width of the step part, and the thickness of the uppers surfaces 1410 of the terminal electrodes 1400. For example, when the thickness of the uppers surfaces 1410 of the terminal electrodes 1400 is approximately 0.1 mm, and the widths of the second inclined region and the step part are approximately 0.05 mm, 0.1 mm, 0.15 mm, 0.2 mm, and 0.25 mm, the bent angle of the wire 1200 may respectively be approximately 40°, 37°, 34°, 32° and 31°. Also, when the thickness of the uppers surfaces 1410 of the terminal electrodes 1400 is approximately 0.15 mm, and the widths of the second inclined region and the step part are approximately 0.05 mm, 0.1 mm, 0.15 mm, 0.2 mm, and 0.25 mm, the bent angle of the wire 1200 may respectively be approximately 42°, 39°, 37°, 35° and 34°. The bent angle of the led-out wire 1200 is favorably be approximately 31° to approximately 42°, and may also be 31° or less when the upper surfaces 1410 of the terminal electrodes 1400 are out of the tangent line of a rounded region. When the bent angle is greater than this, the led-out wire 1200 may be hardly guided by a first bent part of the terminal electrode 1412.

### 1.4. Terminal electrode

The terminal electrodes 1400 are inserted and fastened in the second regions 1320 of the flanges 1300, the wire 1200 is then fixed at the upper portion of the flanges, and the welded parts 1500 are thereby formed. The terminal electrodes 1400 may be formed in an approximately "C" shape so as to be inserted and fastened in the flanges 1300. That is, the terminal electrodes 1400 each include an upper surface 1410, a lower surface 1420, and a side surface 1430 provided to connect the upper and lower surfaces. Accordingly, the upper surface 1410, the lower surface, and the side surface 1430 may be formed in an approximately "C" shape. Here, the upper surface 1410 may be provided in an approximately plate-like shape. That is, the upper surface 1410 may include: a first side contacting the side surface 1430, a second side facing the first side; a third side contacting the step portions of the first and second regions 1310 and 1320, and a fourth side facing the third side. In addition, the lower surface 1420 may be provided in an approximately rectangular plate shape having first to fourth sides corresponding to the first to fourth sides of the upper surface 1410, and the side surface 1430 may be provided in an approximately rectangular plate shape having a height corresponding to the distance between the upper surface 1410 and the lower surface 1420. The terminal electrodes 1400 are inserted into the second regions 1320 of the flanges 1300 from the opened region thereof facing the side surfaces 1430, the upper and lower surfaces 1410 and 1420 respectively contact the upper and lower surfaces of the second region 1320 of the flanges 1300, and the side surfaces 1430 contact the front surfaces of the second regions 1320 such that the terminal electrodes 1400 are fastened to the flange 1300. In this case, since predetermined inclinations are formed between the upper and front surfaces of the second regions 1320 of the flanges 1300, the upper surfaces of the terminal electrodes 1400 may be moved to the upper surfaces of the flanges 1300 along inclined surfaces. Also, the side surfaces 1430 and lower and upper surfaces 1410 and 1420 of the terminal electrodes 1400 may define a right angle. However, to further increase coupling force by using a pressing force of either of upper and lower surfaces 1410 and 1420, an acute angle of approximately 90° or less, for example, approximately 80° may be formed between the side surfaces 1430 and the upper and lower surfaces 1410 and 1420 of the terminal electrodes 1400.

Meanwhile, in the terminal electrodes 1400, the lower surfaces 1420 may be formed greater than the upper surfaces 1410. The lower surfaces 1420 may be formed to cover the entire lower surfaces of the second regions 1320 of the flanges 1300, and the upper surfaces 1410 may be formed to cover portions of the upper surfaces of the second regions 1320. That is, in the second regions 1320 of the flanges 1300, for example, roundly formed second regions are formed between the rear and upper surfaces, and the upper surfaces 1410 of the terminal electrodes 1400 may be formed to extend to the borders of the upper surfaces and the second inclined regions or may be formed smaller than this. This is because when the upper surfaces 1410 are formed greater than the second inclined regions, a space is formed between the upper surfaces 1410 and the second inclined regions, the wire 1200 is led out along one surface of the upper surfaces 1410, and thus, the wire 1200 may be cut or the coating of the wire 1200 may be peeled off due to an edge portions of the upper surfaces 1410.

Also, on the upper surfaces 1410 of the terminal electrodes 1400, first and second bent parts 1411 and 1412 for fixing ends of the wire 1200 may be formed. The first bent parts 1411 temporarily fix the ends of the wire 1200, and the second bent parts 1412 fix the ends of the wire 1200 and form the welded parts 1500 with the wire 1200. That is, a portion of the wire 1200 and the second bent parts 1412 are melted and the welded parts 1500 may thereby be formed.

In the terminal electrodes 1400, the first bent parts 1411 may be formed on one side of the upper surfaces 1410 contacting the side surfaces 1430 of the terminal electrodes 1400 and on the other side. That is, the first bent parts 1411 may be formed on the upper surface 1410 on the first side contacting the side surfaces 1430, and the second side facing the first side. Also, the first bent parts 1411 may be formed adjacent to step portions between the first and second regions 1310 and 1320 of the flanges 1300. That is, the first bent part 1411 may be formed in a predetermined width from edge regions between the second and third sides to the third side. The first bent parts 1411 may be formed in a shape of extending to have a predetermined height from the third sides of the upper surfaces 1410 and extending again in one direction. That is, the first bent parts 1411 each may have a height part, formed in a predetermined height from the upper surfaces 1410, and a horizontal part extending from an end of the height part in an opposite direction to the first regions 1310 of the flanges 1300, that is, in the direction of fourth sides of the upper surfaces 1410. Accordingly, the first bent parts 1411 may be formed, for example, in an "L"-shape in the direction of the fourth sides. As such, the first bent parts 1411 are formed adjacent to the step portions of the flanges 1300, the wire 1200 may be led out by being guided by the height parts and the horizontal parts of the first bent parts 1411. That is, since the wire 1200 may be led out between the height parts and the horizontal parts of the "L"-shaped first bent parts 1411, the wire 1200 may be prevented from being detached. Also, the height parts of the first bent parts 1411 may be bent in the led-out direction of the wire 1200, that is, in the opposite direction to the core 1100. Accordingly, the horizontal parts of the first bent parts 1411 contact the upper surfaces 1410 in a direction perpendicular to the led-out direction of the wire 1200, that is, between the third and fourth sides of the upper surfaces 1410, and the horizontal parts thereby temporarily fix the wire 1200.

The second bent parts 1412 may be provided to be space apart from the first bent parts 1411. For example, the second bent parts 1412 may be formed on the third sides of the upper surfaces 1410 of the terminal electrodes 1400, the third sides contacting the step portions of the flanges 1300. That is, the second bent parts 1412 each may include: a height part provided in a predetermined height over a predetermined region of the third sides of the upper surfaces 1410; and a horizontal part formed in a predetermined size from the end of the height part. In this case, the horizontal part may be formed wider than the width of the height part. That is, the horizontal parts of the second bent parts 1412 may be formed greater than the first bent parts 1411 in consideration of the size etc. of the welded parts 1500. For example, the horizontal parts of the second bent parts 1412 may be formed to become wider in the direction of the first sides from the height parts. Also, the second bent parts 1412 may be bent in a direction perpendicular to the bending direction of the first bent parts 1411. That is, the height parts of the first bent parts 1411 are bent in the direction of the first sides from the second sides of the upper surfaces 1410, and the second bent parts 1412 are bent to the direction of the fourth sides from the third sides of the upper surfaces 1410. Accordingly, the horizontal parts of the first bent parts 1411 and the horizontal parts of the second bent parts 1412 fix the wire 1200 in the same direction. As such, the wire 1200 may contact and may be fixed onto the upper surfaces 1410 of the terminal electrodes 1400 by means of the first and second bent parts 1411 and 1412.

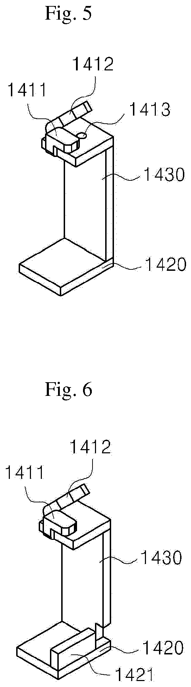

Meanwhile, as illustrated in FIG. 5, an opening 1415 may be formed in each upper surface 1410 of the terminal electrodes 1400. The opening 1413 may be formed in predetermined width and length, and the wire 1200 may be positioned thereon. That is, as the opening 1413 is formed, the upper surface of the second region 1320 of each flange 1300 may be exposed under the wire 1200. Here, the opening 1413 may be formed in a width greater than the width of the wire 1200, and in a length smaller than the length of the wire 1200 mounted on each upper surface 1410. Accordingly, the wire 1200 floats above the opening 1413, and the endmost portion of the wire 1200 may contact the upper surface 1410 of each terminal electrode 1400. That is, the wire 1200 contacts the upper surface 1410 by a predetermined width from the endmost portion of the wire 1200, and a portion of the wire 120 may float on the opening 1413. Of course, a portion of the wire 1200 may contact the flange 1300 through the opening 1413. As such, the wire 1200 and the second bent part 1412 are positioned above the opening 1413, the wire 1200 and the second bent part 1412 are melted through laser irradiation, and each welded part 1500 may thereby be formed. That is, the welded part 1500 may be positioned above the opening 1413. As such, as the openings 1413 are formed in the upper surfaces 1410 of the terminal electrodes 1400, energy due to laser during laser irradiation for forming the welded parts 1500 may be prevented from being conducted to the upper surfaces 1410 of the terminal electrodes 1400 through the wire 1200. Accordingly, the deformation of the upper surfaces 1410 of the terminal electrodes 1400 due to the heat generated during laser irradiation may be prevented, and the welded parts 1500 may be formed with optimal energy. Also, energy conducted to the wound wire 1200 may be decreased to prevent a short circuit. In addition, air layers due to the openings 1413 are formed between the welded parts 1500 and the flanges 1300, and thus, a quick cooling effect may be expected after the welded parts 1500 are formed, and the shape of the welded parts 1500 may be stably maintained.

In addition, as portions of the welded parts 1500, which are formed while the wire 1200 and the second bent parts 1412 of the terminal electrodes 1400 are welded, are positioned at the openings 1413, the height of the welded parts 1500 generated after the welding may be lowered. Accordingly, since the height space areas of the welded parts 1500 in the Z-direction may be maximally utilized, it is possible to miniaturize the product and perform a low-height design.

Also, step parts may be formed on the lower surfaces of the second regions 1320 of the flanges 1300. That is, the step parts each may be formed between one side surface and the lower surface, which do not contact the first region 1310, in the second region 1320. The step part each may be formed in such a way that a portion of one side surface of the second region 1320 is removed. In this case, the step parts each between the side and lower surfaces of the second regions 1320 may form a right angle or may also form a predetermined inclination. Corresponding to the step parts, as illustrated in FIG. 6, protrusion parts 1421 protruding upward may be formed on edge portions of the lower surfaces 1420 of the terminal electrodes 1400. The protrusion parts 1421 may be formed in a height corresponding to the step parts formed in the lower surfaces of the second regions 1320 of the flanges 1300. As such, the step parts are formed in the lower surfaces of the second regions 1320, the protrusion parts 1421 are provided in the lower portions of the terminal electrodes 1400, and the protrusion parts 1421 are brought into close contact with the step parts. Thus, the terminal electrodes 1400 are coupled and thus, the terminal electrodes 1400 and the flanges 1300 may be more firmly coupled. That is, when the protrusion parts 1421 are not formed, the flanges 1300 are not detached from the terminal electrodes 1400 due to the side, upper, and lower surfaces 1430, 1410 and 1420 of the terminal electrodes 1400 with respect to the vibration in the X- and Z-directions, but the flanges 1300 may be detached from the terminal electrodes 1400 by the vibration in the Y-direction. However, since the protrusion parts 1421 contact the flanges 1300 in addition to the upper, lower, and side surfaces 1410, 1420, and 1430 of the terminal electrodes 1400, the contact surface of the flanges 1300 and the terminal electrodes 1400 is increased. Therefore, the terminal electrodes 1400 may be more strongly fastened, and thus, the terminal electrodes 1400 and the flanges 1300 may be prevented from being separated. In addition, since the protrusion parts 1421 are formed, when the product is mounted on a board, two fillets are formed in the X- and Y-directions. Thus, when a vibration or a strong shock occurs in the board, the core 1100 coupled to the terminal electrodes 1400 mounted on the board and the product may be prevented from being separated. In addition, even when the two fillets of the terminal electrodes 1400 are formed and a crack is generated in a surface in one direction between the terminal surface and the solder fillet, the terminal surface and the solder filler in the crossing direction are maintained. Thus, a short may not be caused, a stable performance may be achieved, and a high reliability may be achieved.

### 1.5. Welded part

The welded parts are formed on the terminal electrodes 1400 fastened to the second regions 1320 of the flanges 1300. The welded parts 1500 may be formed in such a way that the second bent parts 1412 are irradiated with laser while being fixed by the first and second bent parts 1411 and 1412 on the terminal electrodes 1400. That is, the welded parts 1500 may be formed such that the wire 1200 and the second bent parts 1412 are melted. Also, the welded parts 1500 may be formed in a spherical shape. The welded parts 1500 may be formed in a height lower than the first regions 1310 of the flange 1300, and accordingly, the welded parts 1500 may not contact the cover part 1600. Meanwhile, insulating layers (not shown) may remain between the welded parts 1500 and the terminal electrodes 1400. That is, when only an upper portion of the end of the wire 1200 is irradiated with laser, an insulating coating remains in a lower portion of the end of the wire 1200. Therefore, the insulating layers may remain only between the welded parts 1500 and the terminal electrodes 1400 after the welded parts 1500 are formed. However, when the insulating coating of the end of the wire 1200 is completely removed, the insulating layers do not remain between the welded parts 1500 and the terminal electrodes 1400. Furthermore, when the insulating coating in the regions of the wire 1200 positioned on the terminal electrodes 1400 is not removed, the insulating layers may remain not only between the welded parts 1500 and the terminal electrodes 1400 but also in the welded parts 1500. That is, the insulating layers may remain in the welded parts 1500 or may also remain outside the welded parts 1500. That is, according to the method of removing the insulating coating of the wire 1200, the insulating layers may not remain in the welded parts 1500 or may remain in at least one region of the welded parts 1500.

### 1.6. Cover part

The cover part 1600 may be provided on the upper portion of the core 1100 around which the wire 1200 is wound, and to which the terminal electrodes 1400 are fastened. The cover part 1600 may be provided in an approximately rectangular plate shape having a predetermined thickness. In this case, a lower surface of the cover part 1600 may contact the upper portions of the first regions 1310 of the flanges 1300 and may be spaced apart from the welded parts 1500. Of course, the cover part 1600 may be provided in various shapes such that one region thereof is spaced apart from the welded parts 1500. For example, the first regions 1310 of the flanges 1300 and the welded parts 1500 are formed in the same height, and the cover part 1600 is formed such that a lower central portion thereof protrudes. Thus, the protruding portion contacts the upper portions of the first regions 1310 and may not contact the welded parts 1500. In addition, the cover part 1600 may be formed such that recess parts may be formed in portions corresponding to the second regions 1320 of the flanges 1300.

As described above, a noise filter part 1000 of a complex electronic component in accordance with one exemplary embodiment is provided with: flanges 1300 on both end portions of the core 1100 around which the wire 1200 is wound; and "C"-shaped terminal electrodes 1400 in the second regions 1320 of the flanges 1300. Also, inclined surfaces (or round surface) are formed between upper, front, and rear surfaces of the second regions 1320 of the flanges 1300 and thereby facilitate the fastening of the terminal electrodes 1400, and thus, the cut of the wire 1200 led out to the upper surfaces of the terminal electrodes 1400 may be prevented. Also, as the openings 1413 are formed in the upper surfaces 1410 of the terminal electrodes 1400, energy due to laser during laser irradiation for forming the welded parts 1500 may be prevented from being conducted to the upper surfaces 1410 of the terminal electrodes 1400 through the wire 1200. Accordingly, the deformation of the upper surfaces 1410 of the terminal electrodes 1400 due to the heat generated during laser irradiation may be prevented, the welded parts 1500 may be formed with optimal energy, and heat energy conducted to the wound wire 1200 may be decreased to prevent a short circuit.

### 2. 2. ESD protecting part

The ESD protecting part 2000 may include a support plate 2100, and an ESD protecting chip 2200 provided on the support plate 2100. The ESD protecting part 2000 is electrically connected with the noise filter part 1000 and thereby bypasses a high voltage such as an ESD voltage applied from the outside to a ground terminal. To this end, at least a portion of the ESD protecting part 2000 may contact the signal terminal of a wiring board together with the noise filter part 1000, and at least a portion thereof may contact the ground terminal of the wiring board.

### 2.1. Support plate

The support plate 2100 is provided in a plate shape having a predetermined thickness and may be provided in length and width which are the same as those of the noise filter part 1000. That is, the support plate 2100 may be provided to have a length in the X-direction and a width in the Y-direction which are the same as those of the noise filter part 1000. The support plate 2100 may include a plurality of connecting electrodes 2110 and a plurality of led-out electrodes 2120 led out from the plurality of connecting electrodes 2110. Also, the support plate 2100 may include a base 2130 which exposes predetermined portions of and supports the plurality of connecting electrodes 2110 and the plurality of led-out electrodes 2120 and allows the shapes of the connecting electrodes 2110 and the led-out electrodes 2120 to be maintained.

The plurality of connecting electrodes 2111 to 2116 (2110) may be provided to be connected with the terminal electrode 1400 of the noise filter part 1000 and the wiring board. The plurality of connecting electrodes 2110 may be bonded with the terminal electrode 1400 of the noise filter part 1000 by using a conductive adhesive or bonded through a method such as welding or soldering. That is, six connecting electrodes 2110 may be provided such that four thereof are respectively connected with four terminal electrodes 1400, and two thereof are connected to a ground terminal. Here, the connecting electrodes 2110 connected to the terminal electrodes 1400 may be connected with the wiring board, for example, with signal terminals of the wiring board. For example, first to fourth connecting electrodes 2111 to 2114 are connected to the four terminal electrodes 1400 to be thereby connected to the signal terminals of the wiring board, and fifth and sixth connecting electrodes 2115 and 2116 may be provided to be connected to the ground terminal. In this case, the first to fourth connecting electrodes 2111 to 2114 may be provided in a region corresponding to the terminal electrodes 1400 of the noise filter part 1000, that is, in four edge regions, and may preferably be provided in the same size as that of the lower surfaces 1420 of the terminal electrodes 1400. Also, the fifth and sixth connecting electrodes 2115 and 2116 may be formed in the X-direction so as to face each other in the Y-direction. Meanwhile, at least a portion of the connecting electrodes 2110 may be formed in an approximately "C" shape so as to be exposed to the upper, lower, and side surfaces of the base 2130. For example, the first to fourth connecting electrodes 2111 to 2114 may be formed to be exposed to the upper, lower, and side surfaces of the base 2130. Also, the fifth and sixth connecting electrodes 2115 and 2116 may be formed so as to be exposed to the side and lower surfaces of the base 2130. That is, the first to fourth connecting electrodes 2111 to 2114 may be formed so as to be exposed to the upper, lower, and side surfaces of the base 2130 and may thereby be connected with the wiring board. The connecting electrodes 2115 and 2116 which are not connected to the terminal electrode 1400 are formed to be exposed to the lower and side surfaces of the base 2130 and thereby connected to the wiring board. Of course, since the terminal electrodes 1400 are not formed in portions corresponding to the fifth and sixth connecting electrodes 2115 and 2116, the fifth and sixth connecting electrodes 2115 and 2116 may be exposed also to the upper surface of the base 2130. Also, after being formed in the same shape, the plurality of connecting electrodes 2110 may also be formed such that predetermined regions thereof are exposed by the base 2130 to the upper surface of the base 2130. For example, the plurality of connecting electrodes 2110 are formed in an approximately "C" shape having the same size and shape, and then may be formed such that when the base 2130 is formed, the upper, lower, and side surfaces of the first to fourth connecting electrodes 2111 to 2114 are exposed, and the upper surfaces of the fifth and sixth connecting electrodes 2115 and 2116 are not exposed.

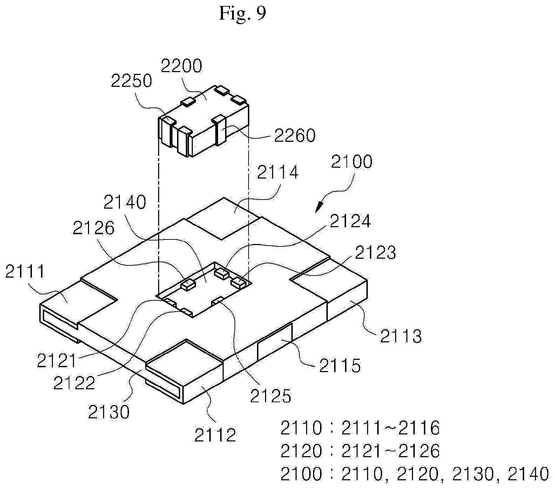

The plurality of led-out electrodes 2120, as illustrated in FIGS. 7 and 8, are formed to be led out inward from predetermined regions of the plurality of connecting electrodes 2110. In this case, the plurality of led-out electrodes 2120 may be provided to be led out toward a central portion between the plurality of connecting electrodes 2110 and spaced apart from each other in a predetermined region in the central region. To this end, the first to fourth led-out electrodes 2121 to 2124 which are led out from the first to fourth connecting electrodes 2111 to 2114 connected with the terminal electrodes 1400 of the noise filter part 1000 are led out in the Y-direction and then led out toward the central portion in the X-direction. That is, the first to fourth led-out electrodes 2121 to 2124 may be formed in an approximately inverted "L" shape or "L" shape which is bent at a predetermined region. Also, the fifth and sixth led-out electrodes 2125 and 2126 which are led out from the fifth and sixth connecting electrodes 2115 and 2116 connected to the ground terminal of the wiring board may be led out toward the central portion in the Y-direction. That is, the fifth and sixth led-out electrodes 2125 and 2126 may be formed in a linear shape. Here, the plurality of led-out electrodes 2120, as illustrated in FIG. 9, may be exposed at the central portion of the base 2130 and connected to an ESD protecting chip 2200.

The base 2130 supports the plurality of connecting electrodes 2110 and the plurality of led-out electrodes 2120 and forms the external shape of the support plate 2100. The base 2130 may be provided in an approximately plate-like shape having a predetermined thickness and may be formed of an insulating material. For example, the base 2130 may be formed of a fluidic material such as LCP, phenol, plastic, or the like. When the base 2130 is formed of a fluidic material, as illustrated in FIG. 7, the plurality of "C"-shaped connecting electrodes 2110 and the plurality of led-out electrodes 2120 led out from the connecting electrodes 2110 are formed, and as illustrated in FIG. 8, the resultant may be impregnated in a fluidic material to form the base 2130. In this case, as illustrated in FIG. 8, the plurality of connecting electrodes 2110 and the plurality of led-out electrodes 2120 may be exposed. That is, the base 2130 may be formed between the upper and lower portions of the "C" shaped connecting electrodes 2110 and may be formed in the thickness of the side portion. Subsequently, as illustrated in FIG. 9, the base 2130 is further formed such that the fifth and sixth connecting electrodes 2115 and 2116 are not exposed at the upper portion of the base 2130, and the end portions of the led-out electrodes 2120 are exposed at the upper portion of the base 2130. In this case, a concave groove is formed in the central portion of the base 2130, that is, the region to which the led-out electrodes 2120 are exposed, and as illustrated in FIG. 10, the ESD protecting chip 2200 may be mounted on the region. That is, a mounting groove 2140 through which at least a portion of the led-out electrodes 2120 is exposed is formed in the central portion of the base 2130 and the ESD protecting chip 2220 may thereby be mounted. Of course, the base 2130 may be formed by laminating a plurality of insulating ceramic plates. In this case, the connecting electrodes, the led-out electrodes, etc. may selectively be formed in the plurality of insulating ceramic plates. Finally, the base 2130 may be formed such that the first to fourth connecting electrodes 2111 to 2114 are exposed at the upper portion thereof, the fifth and sixth connecting electrodes 2115 and 2116 are not exposed at the upper portion thereof, and the end portions of the led-out electrodes 2120 are exposed at the upper portion thereof.

### 2.2 ESD protecting chip

The ESD protecting chip 2200 may be manufactured in an approximately hexahedral shape, mounted on the base 2130, and connected to the led-out electrode 2120. The ESD protecting chip 2200 may include a plurality of sheets 2211, 2212 and 2213 (2210), discharge electrodes 2220 and 2230 selectively formed on the plurality of sheets 2210, and ESD protecting layers 2240 formed between the discharge electrodes 2220 and 2230. Here, the discharge electrodes 2220 and 2230 may be formed in the vertical direction and may also be formed in the horizontal direction. That is, the discharge electrodes 2220 and 2230 may respectively be formed on the sheets 2210 different from each other in the vertical direction and may also be formed on the same sheet 2210. Also, the ESD protecting chip 2200 may further include first and second outer electrodes 2250 and 2260 connected to the discharge electrodes 2220 and 2230. Here, the sheets 2210 may be provided in the same thickness as each other, and at least any one may be provided in a different thickness.

The sheet 2211 is formed on the sheet 2212 on which the discharge electrodes 2220 and 2230, the ESD protecting layers 2240, etc. are formed and thereby functions as a cover layer covering the sheet 2212.

That is, the discharge electrodes 2220 and 2230 and the ESD protecting layer 2240 are not formed on the sheet 2211. Also, the sheet 2211 may be formed in the same thickness as the sheets 2212 and 2213 therebelow and may also be formed thicker than the sheets 2212 and 2213.

The sheet 2212 is provided in the same shape as the sheet 2211, and a plurality of first discharge electrodes 2221, 2222, 2223, and 2224 (2220) are formed on the upper surface of the sheet 2212. Here, the same number of the first discharge electrodes 2220 as that of the plurality of connecting electrodes formed on the support plate 2100 may be formed. For example, four first discharge electrodes 2220 may be formed. The plurality of discharge electrodes 2220 are formed to extend in the X-direction from the two sides facing each other in the Y-direction of the sheet 2212 and to be spaced apart from each other at the central portion of the sheet 2212. That is, the two discharge electrodes 2220 may respectively be formed to extend from the two sides facing each other toward the central portion. Also, a plurality of ESD protecting layers 2241, 2242, 2243, and 2244 (2240) are formed on the sheet 2212, and each of the plurality of ESD protecting layers 2240 may be formed at one end portion of the plurality of first discharge electrodes 2220. That is, holes passing through the sheet 2212 may be respectively at end portions of the plurality of first discharge electrodes 2220, and the ESD protecting layers 2240 may be formed such that an ESD protecting material is embedded or applied in at least a portion of each hole. For example, the ESD protecting layer 2240 may be formed such that the side surfaces of the holes formed in the sheet 2212 are coated with an EXD protecting material and may also be formed such that only at least a portion of the hole region is coated or filled with the ESD protecting material. The ESD protecting material may be formed of at least one conductive material selected from RuO₂, Pt, Pd, Ag, Au, Ni, Cr, W or the like. To form an ESD protecting member 530 using the conductive material, for example, the conductive material is mixed in an organic material, such as polyvinyl alcohol (PVA) or polyvinyl butyral, and the mixture is then applied or filled in the holes, and then, the organic material may be removed by a firing process. In this case, a plurality of pores may be formed in the ESD protecting member 530. For example, a plurality of pores may be formed in the region from which the organic materials are volatilized and removed. Also, the ESD protecting material may also be formed such that a varistor material such as ZnO or an insulating ceramic material such as Al₂O₃ is further mixed in the mixture. Of course, various materials besides the above material may be used as the ESD protecting material. For example, at least any one among porous insulating materials and voids may be used as the ESD protecting material. That is, the porous insulating material may be filled or applied in the holes, voids may also be formed in the holes, and a mixture of porous insulating material and a conductive material may be filled or applied in the holes. Also, a porous insulating material, a conductive material, and voids may be formed to form a layer in the hole. For example, porous insulating layers may be formed between the conductive layers, and voids may be formed between the insulating layers. In this case, voids may also be formed such that a plurality of pores of the insulating layers may be connected to each other. Of course, the inside of the holes are vacant, and the ESD protecting layer 2240 may be formed with voids. Here, a strong dielectric ceramic having a dielectric constant of approximately 50 to 50000 may be used as the porous insulating material. For example, the insulating ceramic may be formed by using a mixture including one or more among dielectric material powder such as MLCC, ZrO, ZnO, BaTiO₃, Nd₂O5, BaCO₃, TiO₂, Nd, Bi, Zn, and Al₂O₃. The porous insulating material may be formed in a porous structure formed with a pore ratio of approximately 30% to approximately 80% such that pores with a size of approximately 1 nm to approximately 5 µm are formed in plurality. In this case, the shortest distance between the pores may be approximately 1 nm to approximately 5 µm. Also, the conductive material used as the ESD protecting material may be formed by using a conductive ceramic, and a mixture including one or more among La, Ni, Co, Cu, Zn, Ru, Ag, Pd, Pt, W, Fe, and Bi may be used as the conductive ceramic. Of course, the ESD protecting layer 2240 may also be formed of voids. That is, the ESD protecting layer 2240 may be formed such that a vacant space is formed between the first and second discharge electrodes 2220 and 2230. Meanwhile, the ESD protecting layer 2240 may be formed such that at least one of the thickness and the width of at least one region is different from those of other regions. For example, the ESD protecting layer 2240 may be formed in a predetermined thickness in the Z-direction, that is, the laminating direction of the sheet and respectively formed in a predetermined width in the X-direction, that is, in the direction in which the first outer electrodes 2250 are formed and in the Y-direction which crosses the X-direction and in which the second outer electrodes 2260 are formed. In the intermediate region of the thickness, the width in the X-direction may be formed greater than the width in the Y-direction. Also, the cross-sectional shape at one cross-section of the ESD protecting layer 2240 may be formed in an ellipse and may be accordingly formed in an egg-like shape. Also in this case, either of the width or thickness of one region may be different from those of other regions.

The second discharge electrode 2230 which extends in the direction of two sides facing each other in the sheet 2213 and is exposed to the two sides is formed on the upper surface of the sheet 2213. That is, the second discharge electrode 2230 may be formed in the direction perpendicular to the forming direction of the first discharge electrodes 2220. Also, an extension part of the second discharge electrode 2230 is formed in the region overlapping at least a portion of the ESD protecting layers 2240. That is, the second discharge electrode 2230 is formed in a first width, and an extension part formed in a second width greater than the first width is formed in the portion overlapping the ESD protecting layers 2240, that is, the portion connected to the ESD protecting layers 2240. The second discharge electrode 2230 is connected with the second outer electrodes 2260 formed on two sides facing each other in a laminated body.

The first outer electrodes 2250 may respectively be provided to a first side surface of the laminated body, in which sheets 2210 are laminated, and a second side surface facing the first side surface, and two first outer electrodes may be respectively provided to the first and second side surfaces. The first outer electrodes 2250 may respectively be connected to the led-out electrodes 2120 of the support plate 2100 and the first discharge electrodes 2220 of the ESD protecting chip 2200. Also, the first outer electrodes 2250 may be connected with the led-out electrodes 2120 and the terminal electrodes 1400 of the noise filter part 1000 through the connecting electrodes 2110. Accordingly, the terminal electrodes 1400 of the noise filter part 1000 and the first discharge electrode 2220 of the ESD protecting part 2000 may be connected to the signal lines of the wiring board.

The second outer electrodes 2260 may respectively be provided one by one on third and fourth side surfaces facing each other in the laminated body in which the first outer electrodes 2250 are not formed. The second outer electrodes 2260 may be connected with the second discharge electrodes 2230 of the ESD protecting chip 2200. That is, the second outer electrode 2260 may be provided in the third and fourth side surfaces of the laminated body and connected to the second discharge electrodes 2230. Also, the second electrodes 2260 may be connected to the ground terminal through portions of the led-out electrodes 2120 and the connecting electrodes 2110. Accordingly, an ESD voltage may be bypassed to the ground terminal.

Meanwhile, the first and second outer electrodes 2250 and 2260 may be formed in at least one layer. The first and second outer electrodes 2250 and 2260 may be formed in a metal layer of Ag, etc., and at least one plating layer may be formed on the metal layer. For example, in the first and second outer electrodes 2250 and 2260, copper layer, Ni plating layer, and Sn or Sn/Ag plating layer may be laminated and formed. Also, the first and second outer electrodes 2250 and 2260 may be formed by mixing, with metal powder, glass frit having, for example, approximately 0.5% to approximately 20% of Bi₂O₃ or SiO₂ as main ingredients. In this case, the mixture of the glass frit and the metal powder may be manufactured in a paste shape and applied onto the two surfaces of the laminated body 10 which face each other. As such, as the glass frit is included in the first and second outer electrodes 2250 and 2260, the adhesive force of the first and second electrodes 2250 and 2260 and the laminated body 10 may be improved, and the contact reaction of the led-out electrodes 2200, the discharge electrodes 2220 and 2230, and the first and second outer electrodes 2250 and 2260 may be improved. Also, the first and second outer electrodes 2250 and 2260 may be formed such that after the conductive paste including glass is applied, at least one plating layer is formed thereon. That is, the first and second outer electrodes 2250 and 2260 may be formed such that the metal layer including glass is formed and then at least one plating layer are formed thereon. For example, the first and second outer electrodes 2250 and 2260 may be formed such that a layer including glass frit and at least one among Ag and Cu is formed, and then a Ni plating layer and a Sn plating layer are sequentially formed through electroplating or electroless plating. In this case, the Sn plating layer may be formed in the same as or greater than that of the Ni plating layer. Meanwhile, the first and second outer electrodes 2250 and 2260 may be formed in a thickness of approximately 2 µm to approximately 100 µm, the NI plating layer may be formed in a thickness of approximately 1 µm to approximately 10 µm, and the Sn or Sn/Ag plating layer may be formed in a thickness of approximately 2 µm to approximately 10 µm.

As described above, in a complex electronic component in accordance with an exemplary embodiment, a drum core-type noise filter part 1000 and an ESD protecting part 2000 may be integrally manufactured. That is, the terminal electrodes 1400 of the noise filter part 1000 and the first to fourth connecting electrodes 2111 to 2114 of the ESD protecting part 2000 are connected, and the first to fourth connecting electrodes 2111 to 2114 are mounted on, for example, the signal input/output terminals of a wiring terminal. Also, the fifth and sixth connecting electrodes 2115 and 2116 may be mounted on the ground terminal of the wiring terminal. Such a complex electronic component may remove common-mode noises by using the noise filter part 1000 and may remove ESD such as static electricity (or surge) by using the ESD protecting part 2000. That is, the common-mode noises may be removed by the noise filter part 1000, and the ESD voltage applied from the outside may be bypassed to a ground terminal through the ESD protecting part 2000.

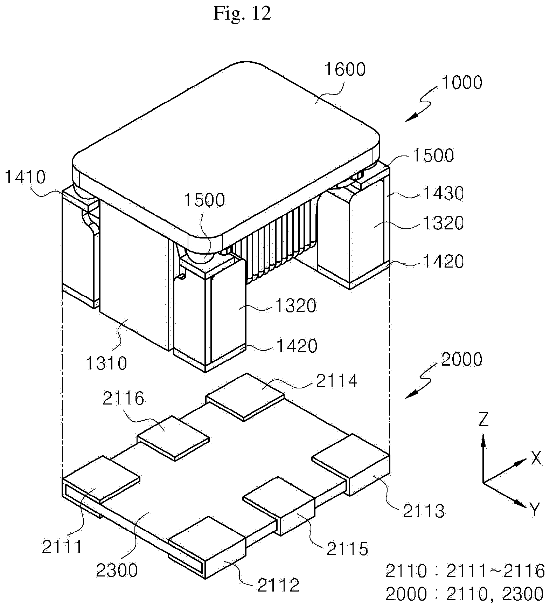

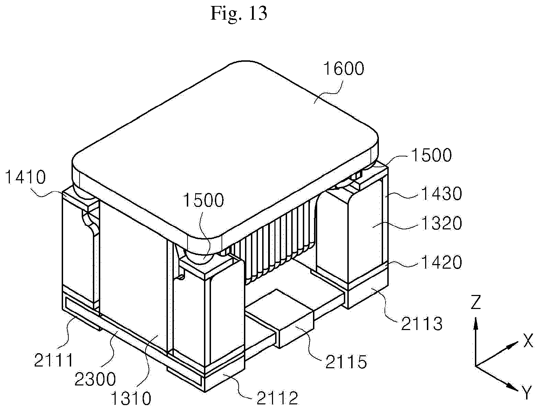

FIGS. 12 and 13 are an exploded perspective view and an assembled perspective view of a complex electronic component in accordance with a second exemplary embodiment.

As illustrated in FIGS. 12 and 13, a complex electronic component in accordance with a second exemplary embodiment may include a noise filter part 1000 and an ESD protecting part 2000 connected with the noise filter part 1000. Here, the noise filter part 1000 may have the same configuration as the noise filter 1000 in accordance with the first exemplary embodiment which is described with reference to FIGS. 1 to 6. That is, the noise filter part 1000 may include: a core 1100; a wire 1200 wound around the core 1100; flanges 1300 provided on both end portions of the core 1100 such that both sides thereof are provided in heights lower than the central portions; terminal electrodes 1400 fastened to both the sides of the flanges 1300; welded parts 1500 formed on the terminal electrodes 1400; and a cover part 1600 provided above the core 1100. Also, the ESD protecting part 2000 may be provided in a lower portion of the noise filter part 1000 in a plate shape contacting the terminal electrodes 1400. In this case, the ESD protecting part 2000 may include an ESD protecting member 2300 and a plurality of connecting electrodes 2110 formed on side surfaces of the ESD protecting member 2300. Here, the ESD protecting member 2300 may have, for example, the same configuration as the ESD protecting chip 2200 described with reference to FIG. 11. That is, the ESD protecting member 2300 may include: first discharge electrodes formed on at least one insulating sheet, a second discharge electrode formed on at least one insulating sheet, and an ESD protecting layer formed between the first and second discharge electrodes. In other words, the ESD protecting part 2000 filter in accordance with the second exemplary embodiment may be provided in a plate shape which has the same shape as and greater size than the ESD protecting chip 2200 described in the first exemplary embodiment. Also, the ESD protecting member 2300 may also be formed of a varistor material or a diode material which has a yielding voltage less than the ESD voltage and greater than the rated voltage. Here, the rated voltage may be the same as or greater than the operating voltage of a circuit, and the ESD voltage may be greater than the rated voltage. For example, a sheet may be manufactured by using Pr-, Bi-, ST-based ceramic material. That is, the ESD protecting member 2300 may be formed such that a plurality of sheets are manufactured by using a varistor material or a diode material and then laminated, and the connecting electrodes 2110 are formed outside a laminated body. In this case, a plurality of inner electrodes are formed in the laminated body, and when an ESD voltage is applied, the ESD voltage may be discharged through the sheet between the inner electrodes.

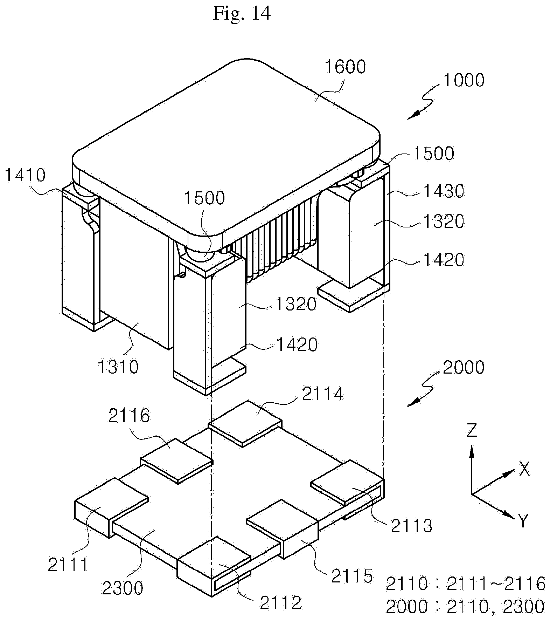

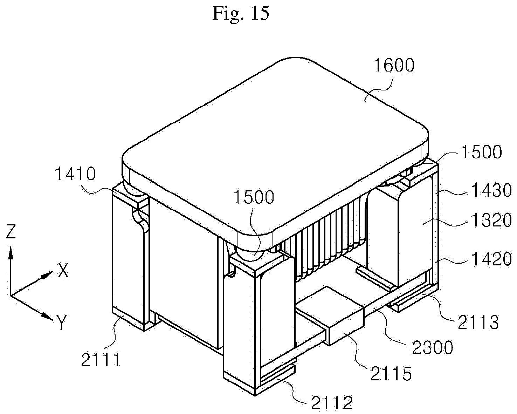

FIGS. 14 and 15 are an exploded perspective view and an assembled perspective view of a complex electronic component in accordance with a third exemplary embodiment.

As illustrated in FIGS. 14 and 15, a complex electronic component in accordance with a third exemplary embodiment may include a noise filter part 1000 and an ESD protecting part 2000 connected with the noise filter part 1000. Here, the noise filter part 1000 may have the same configuration as the noise filter 1000 in accordance with the first exemplary embodiment described with reference to FIGS. 1 to 6. Also, the ESD protecting part 2000 may be provided in a lower portion of the noise filter part 1000 in a plate shape contacting the terminal electrodes 1400. In this case, the ESD protecting part 2000 may have the same configuration as the ESD protecting part 2000 described with reference to FIGS. 12 and 13. That is, the ESD protecting part 2000 may include an ESD protecting member 2300 and a plurality of connecting electrodes 2110 formed on side surfaces of the ESD protecting member 2300. Of course, the ESD protecting part 2000 may also have the structure described in the first exemplary embodiment. That is, the ESD protecting part 2000 may include a support plate 2100, and an ESD protecting chip 2200 provided in a mounting groove on the support plate 2100. However, in the third exemplary embodiment, the terminal electrodes 1400 extends downward and the ESD protecting part 2000 may be inserted between the terminal electrodes 1400 and the flanges 1300. That is, the terminal electrodes 1400 may be formed by being connected in the thickness of the ESD protecting part 2000 below the flanges 1300. and the ESD protecting part 2000 may be inserted between the terminal electrodes 1400 and the flanges 1300.

As such, The ESD protecting part 2000 is inserted between the terminal electrodes 1400 and the flanges 1300 and may thereby be more firmly fixed. Accordingly, the ESD protecting part 2000 may be prevented from being detached due to a shock or the like.

Also, the noise filter part 1000 of exemplary embodiments may be modified in various shapes, and such various embodiments of the noise filter part 1000 will be described as follows using drawings.

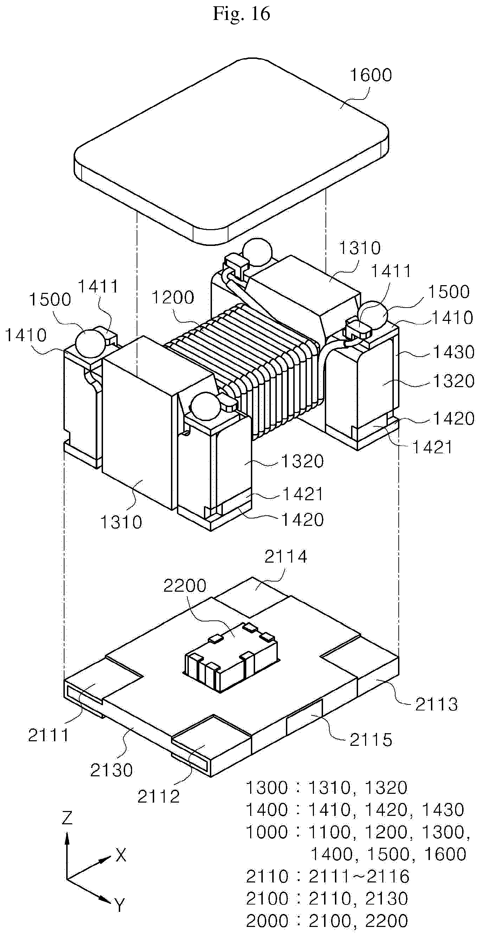

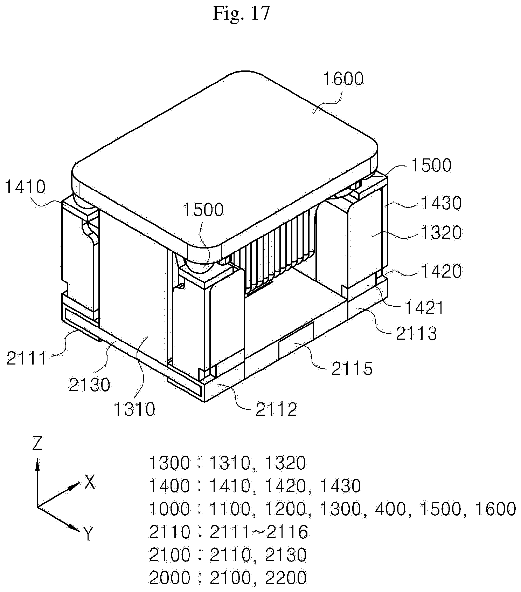

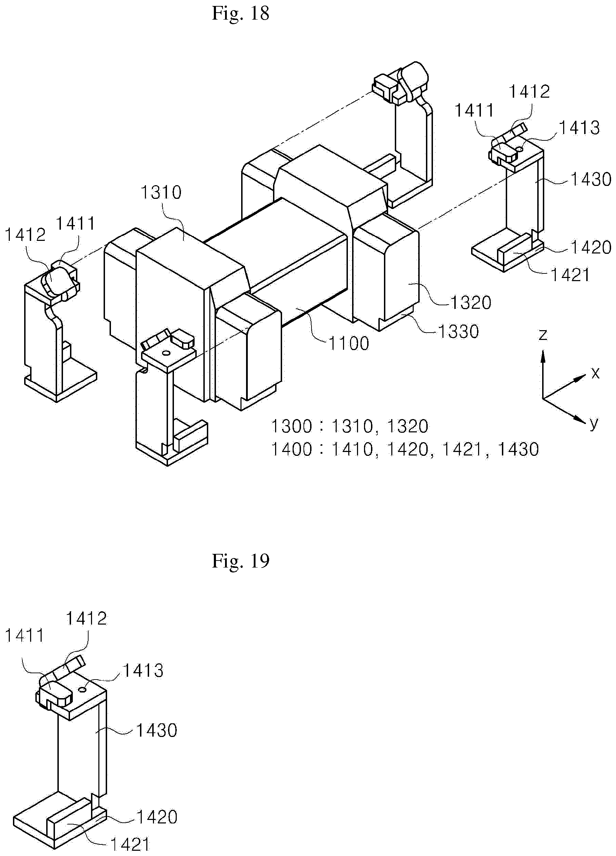

FIG. 16 is an exploded perspective view of a complex electronic component in accordance with another exemplary embodiment and FIG. 17 is an assembled perspective view. In addition, FIG. 18 is an exploded perspective view before a welding portion of a noise filter part in accordance with another exemplary embodiment. In addition, FIG. 19 is a structural view of a terminal electrode of a noise filter part in accordance with another exemplary embodiment.

Referring to FIGS. 16 to 19, a noise filter part 2000 in accordance with another exemplary embodiment may include: a core 1100; a wire 1200 wound around the core 1100; flanges 1300 each provided with a first region 1310 provided on both end portions of the core 1100 and contacting the core 1100 and a second region 1320 provided on both sides of the first region 1320 in a lower height than the first region 1320; terminal electrodes 1400 fastened to both sides of the flanges 1300 and engaged with step parts 1330 of the flanges 1300; and a cover part 1600 provided above the core 1100, wherein step parts 1330 may be further provided in the lower portions of the flanges 1300. That is, in another exemplary embodiment, openings 1413 may be formed in upper surfaces 1410 of the terminal electrodes 1400, the step parts 1330 may be formed in lower portions of the second regions 1320, and protrusion parts 1421 may be formed on lower surfaces 1420 corresponding to the step parts 1330 in the terminal electrodes 1400.

The step parts 1330 may be formed on the lower surfaces of the second regions 1320 of the flanges 1300. That is, the step parts 1330 each may be formed between one side surface and the lower surface, which do not contact the first region 1310, in the second region 1320. The step part 1330 each may be formed in such a way that a portion of one side surface of the second region 1320 is removed. In this case, the step parts 1330 each between the side and lower surfaces of the second regions 1320 may form a right angle or may also form a predetermined inclination. Corresponding to the step parts 1330, protrusion parts 1421 protruding upward may be formed on edge portions of the lower surfaces 1420 of the terminal electrodes 1400. The protrusion parts 1421 may be formed in a height corresponding to the step parts 1330 formed in the lower surfaces of the second regions 1320 of the flanges 1300. As such, the step parts 1330 are formed in the lower surfaces of the second regions 1320, the protrusion parts 1421 are provided in the lower portions of the terminal electrodes 1400, and the protrusion parts 1421 are brought into close contact with the step parts 1330. Thus, the terminal electrodes 1400 are coupled and thus, the terminal electrodes 1400 and the flanges 1300 may be more firmly coupled.

Meanwhile, in the above exemplary embodiment, the case in which the "C"-shaped terminal electrodes 1400 are inserted into the flanges 1300 and fastened, have been described. However, the terminal electrodes 1400 may also be formed on the flanges 1300 through plating or soldering. For example, as illustrated in FIG. 3, the terminal electrodes 1400 may be formed through plating or soldering on the second regions 1320 of the flanges 1300. That is, the complex electronic component of exemplary embodiments may be realized by coupling a drum core-type common-mode filter formed by plating, soldering, or fastening terminal electrodes and an ESD protecting part.

Although the technical concept of the present invention has been specifically described according to the above exemplary embodiments, it should be understood that the above embodiments are provided not to limit but to describe the technical concepts. It will be readily understood by those skilled in the art that various modifications and changes can be made thereto without departing from the spirit and scope of the present invention.

## Claims

1. A complex electronic component comprising:
a noise filter part including a wire wound around a core and removing a noise signal; and
an ESD protecting part coupled to the noise filter part and protecting an ESD.

2. The complex electronic component of claim 1, wherein the noise filter part comprises:
flanges provided on both end portions of the core; terminal electrodes to which the wire is upwardly led out; and
welded parts provided on the terminal electrodes.

3. The complex electronic component of claim 2, wherein the terminal electrodes may be formed through plating or soldering or formed by being fastened to the flanges.

4. The complex electronic component of claim 2, wherein the wire comprises a metal wire and an insulating coating for coating the metal wire, and at least a portion of the insulating coating at portions upwardly led out to the terminal electrodes may be removed.

5. The complex electronic component of claim 2, wherein the wire comprises a metal wire and an insulating coating for coating the metal wire, and at least a portion of the insulating coating is removed, the portion extending and being led out to the outside of the terminal electrodes and being located outside the terminal electrodes.

6. The complex electronic component of claim 5, wherein the insulating coating remains between the welded parts and the terminal electrodes or in at least one region of the welded parts.

7. The complex electronic component of claim 2, wherein the ESD protecting part is connected to the terminal electrodes of the noise filter part.

8. The complex electronic component of claim 7, wherein the ESD protecting part is inserted between the flanges and the terminal electrodes.

9. The complex electronic component of claim 7 or 8, wherein the ESD protecting part comprises: a support plate provided with a plurality of connecting electrodes and a plurality of led-out electrodes led out from the connecting electrodes; and an ESD protecting chip provided in a predetermined region in the support plate.

10. The complex electronic component of claim 9, wherein at least a portion of the plurality of connecting electrodes is connected to the terminal electrodes and thereby mounted on a wiring board, and at least another portion the plurality of connecting electrodes is connected to a ground terminal.

11. The complex electronic component of claim 10, wherein the support plate comprises a mounting groove formed such that a predetermined region of the led-out electrodes is exposed, and the ESD protecting chip is mounted on the mounting groove.

12. The complex electronic component of claim 7 or 8, wherein the ESD protecting part comprises an ESD protecting member and a plurality of connecting electrodes formed on side surfaces of the ESD protecting member.
